# EUROPÄISCHE PATENTSCHRIFT

(11) **EP 2 773 598 B1**
(45) Veröffentlichungstag und Bekanntmachung des Hinweises auf die Patenterteilung: **17.10.2018**
(21) Anmeldenummer: 12778341.3
(22) Anmeldetag: 24.10.2012
(51) Int. Cl.: C04B 35/491, C04B 35/638, C04B 35/634, C04B 35/626, H01L 41/43, H01L 41/083, H01L 41/273, H01L 41/187

(54) **KERAMIKMATERIAL, VERFAHREN ZUR HERSTELLUNG DESSELBEN UND ELEKTROKERAMISCHES BAUELEMENT UMFASSEND DAS KERAMIKMATERIAL**
CERAMIC MATERIAL, METHOD FOR PRODUCING THE CERAMIC MATERIAL, AND ELECTROCERAMIC COMPONENT COMPRISING THE CERAMIC MATERIAL
MATÉRIAU CÉRAMIQUE, PROCÉDÉ DE PRODUCTION DUDIT MATÉRIAU ET COMPOSANT ÉLECTRO-CÉRAMIQUE COMPORTANT LE MATÉRIAU CÉRAMIQUE

(30) Priorität: 04.11.2011 DE 102011117709
(43) Veröffentlichungstag der Anmeldung: 10.09.2014
(73) Patentinhaber: Epcos AG, 81671 München (DE)
(72) Erfinder: GLAZUNOV, Alexander, A-8530 Deutschlandsberg (AT); FELTZ, Adalbert, A-8530 Deutschlandsberg (AT)
(74) Vertreter: Epping - Hermann - Fischer
(86) Internationale Anmeldenummer: PCT/EP2012/071081
(87) Internationale Veröffentlichungsnummer: WO 2013/064406

(56) Entgegenhaltungen:
- US-B2- 7 855 488
- HIZEBRY ET AL: "Effect of Nb and K doping on the crack propagation behaviour of lead zirconate titanate ceramics", JOURNAL OF THE EUROPEAN CERAMIC SOCIETY, ELSEVIER SCIENCE PUBLISHERS, BARKING, ESSEX, GB, Bd. 27, Nr. 2-3, 19. November 2006 (2006-11-19), Seiten 557-560, XP005729620, ISSN: 0955-2219, DOI: 10.1016/J.JEURCERAMSOC.2006.04.073

## Beschreibung

Keramikmaterial, Verfahren zur Herstellung desselben und elektrokeramisches Bauelement umfassend das Keramikmaterial Es wird ein Keramikmaterial angegeben, umfassend Bleizirkonat-Titanat, das zusätzlich K und Cu enthält.

US 7,855,488 B2 offenbart eine piezoelektrische Vorrichtung umfassend ein Bleizirkonat-Titanat-Keramikmaterial und Kupfer-Elektroden. Wesentliche Voraussetzung für die Performance von Bleizirkonat- Titanatmaterielien sind die Anpassung der Zusammensetzung an die morphotrope Phasengrenze (MPG), ein hinreichendes Kornwachstum und die Anpassung der Sintertemperatur an das verwendete Elektrodenmaterial.

Eine Aufgabe der Erfindung besteht darin, ein Keramikmaterial mit verbesserter Leistung für elektrokeramische Bauelemente bereitzustellen.

Die Aufgabe wird durch ein Keramikmaterial nach dem Anspruch 1 gelöst. Weitere Ausführungsformen des Keramikmaterials sowie ein Herstellungsverfahren für das Keramikmaterial und elektrokeramische Bauelemente mit dem Keramikmaterial sind Gegenstand weiterer Patentansprüche. Des weiteren wird in einem unabhängigen Anspruch das Verfahren zur Herstellung eines Vielschichtbauelements beansprucht.

Die beschriebene Aufgabenstellung wird durch die Zugabe von K und Cu zu einem Keramikmaterial, umfassend Bleizirkonat-Titanat gelöst.

Durch die Zugabe von K und Cu zu dem Bleizirkonat-Titanat kann bei der Herstellung die Korngröße der Keramik gesteuert werden. Die Korngröße steht in direktem Zusammenhang mit den piezzoelektrischen Eigenschaften der Keramik.

Durch geeignete Wahl des Zirkonat-Titanat-Anteils in der Keramik kann die Zusammensetzung auf die MPG eingestellt werden.

Die mechanischen Spannungen in einer Bleizirkonat-Titanat-Keramik (PZT-Keramik) resultieren aus der für dieses Material charakteristischen ferroelektrischen Phasenumwandlung, die beim Abkühlen im Bereich von ca. 330°C, der sogenannten Curietemperatur (T_{C}), stattfindet. Diese besteht in einer tetragonalen und im Bereich der morphologischen Phasengrenze (MPG) zugleich anteilweise auch rhomboedrischen Verzerrung der oberhalb T_{C} vorhandenen kubischen Struktur. Zwecks Minimierung der daraus resultierenden lokalen mechanischen Spannungen zerfällt jedes Kristallkorn der Keramik in Domänen. Diese umfassen ca. 10⁹ Elementarzellen. Das sind Bezirke gleicher Ausrichtung der tetragonalen bzw. rhomboedrischen (polaren) Achse, die vorzugsweise im Winkel von 90° aneinander grenzen und damit sogenannte Domänenwände bilden. Bei Ausrichtung der polaren Achse in einem angelegten elektrischen Feld verschieben sich die Domänenwände, und diese Bewegung wird unter anderem durch die Korngrenzen im Gefüge der Keramik gehemmt. Die Dichte der Korngrenzen ist im Volumen der Keramik umso geringer je größer der mittlere Korndurchmesser ist. Folglich ist vor allem zur Gewährleistung einer hinreichenden Domänenwandbeweglichkeit und damit zum Erreichen einer hohen Performance der PZT-Keramik ein hinreichendes Kornwachstum erforderlich.

Die Bleizirkonat-Titanat-Keramik weist ein Perowskit-Gitter auf, welches sich durch die allgemeine Formel ABO₃ beschreiben lässt, wobei A für die A-Plätze und B für die B-Plätze des Perowskit-Gitters stehen.

Eine Elementarzelle des PZT-Kristallgitters lässt sich durch einen Kubus beschreiben. Die A-Plätze sind durch Pb²⁺-Ionen besetzt, welche auf den Ecken des Kubus sitzen. In der Mitte jeder Kubusfläche sitzt jeweils ein O²⁻-Ion. Im Zentrum des Kubus befindet sich ein Ti⁴⁺-Ion bzw. ein Zr⁴⁺-Ion. Diese Struktur weist eine hohe Toleranz gegenüber Substitution der Metall-Ionen durch andere Metall-Ionen und Leerstellen auf. Dotierungen sind dadurch in relativ weiten Grenzen möglich.

Je nach Größenunterschied zwischen dem durch Dotierung eingeführten Ion und dem ersetzten Ion kann es zu einer zusätzlichen lokalen Verzerrung im Koordinationspolyeder kommen.

Die verschiedenen Möglichkeiten der Dotierung lassen sich anhand der Wertigkeit des Dotierungsions klassifizieren. Die isovalente Dotierung, also der Ersatz eines Ions durch ein anderes Ion mit gleicher Wertigkeit wirkt sich nicht auf mögliche Leerstellen im Keramikmaterial aus. Ersetzen niederwertige Kationen (Akzeptoren) Kationen mit einer höheren Wertigkeit, so werden Leerstellen im Anionen-Gitter erzeugt. Höhervalente Kationen (Donatoren) verursachen, wenn sie niederwertigere Kationen ersetzen, Leerstellen im Kationen-Gitter. Die Dotierung mit Akzeptoren und Donatoren führt jeweils zu charakteristischen Änderungen der Materialeigenschaften.

In einem Ausführungsbeispiel der Erfindung nehmen Nd, K und Cu A-Plätze im Perowskit-Gitter ein.

Eine Dotierung mit Nd³⁺ auf den A-Plätzen stellt eine Donator-Dotierung dar. Aufgrund des Ionenradius von Neodym wird dieses auf den Pb²⁺-Plätzen eingebaut und aufgrund der Überschussladung durch Nd· symbolisiert. Der Ladungsausgleich erfolgt durch die entsprechende Bildung von Pb-Leerstellen (V_{Pb}"). Die Auswirkung der Dotierung sind metrische Änderungen des Gitters und die Beeinflussung weitreichenderer Wechselwirkungen zwischen den Elementarzellen.

Eine Dotierung mit K⁺ auf den A-Plätzen und damit anstelle von Pb²⁺ stellt eine Akzeptor-Dotierung dar. Weil jetzt an dem Gitterplatz eine positive Ladung fehlt, wirkt bei diesem Defekt eine negative Überschussladung aus der Gitterumgebung. Sie wird daher durch K' symbolisiert. Diese Akzeptordotierung wird durch die Nd³⁺-Donatordotierung mit einer positiven Überschussladung, symbolisiert durch Nd·, die stets größer ist als die Akzeptordotierung, kompensiert, so dass sich neutrale [K'/ Nd·-Defektpaare bilden. Das bedeutet, dass durch die Akzeptordotierung die Konzentration der Leerstellen V_{Pb}" verringert ist; denn nur der überschüssige Anteil der Donatordotierung trägt zu ihrer Bildung bei. Bei der Sintertemperatur dissoziieren die Defektpaare. Dabei induzieren 2 Nd·-Defekte die Bildung einer V_{Pb}"-Leerstelle und die 2 K'-Defekte die Bildung einer Sauerstoff-Leerstelle V_{O}", und letztere sind für das Kornwachstum und die Sinterverdichtung besonders förderlich. Im Prozess der Abkühlung erfolgt Rekombination zu den wieder quasi neutralen [K'/ Nd·] -Defektpaaren, so dass in der fertigen Keramik keine oder eine nur sehr geringe Sauerstoff-Leerstellenkonzentration vorliegt. Dagegen sind Blei-Leerstellen entsprechend dem Überschuss der Donator-Dotierung noch vorhanden. Diese Dotierung wirkt sich auf das Kornwachstum des Materials aus, welches von der Konzentration der eingebrachten Dotierung abhängig ist. Kleine Dotierungsmengen tragen hierbei zum Kornwachstum bei, wohingegen zu große Mengen an Dotierungsionen das Kornwachstum hemmen können.

Die Donator- Dotierung mit Nd· erhöht auf Grund der Bildung von Pb-Leerstellen V_{Pb}" die Domänenwandbeweglichkeit und damit die Ausrichtbarkeit der Domänen im angelegten elektrischen Feld, was zu hohen Werten für die dielektrische Polarisation führen kann. Andererseits wird durch die Donator-Dotierung infolge der Unterdrückung der Bildung von Sauerstoff-Leerstellen eine Hemmung des Wachstums der Kristallite wirksam, so dass infolge der höheren Dichte von Korngrenzen in der Keramik die Mobilität der Domänenwände mit zunehmender Donator-Dotierung immer mehr eingeschränkt ist, was zu einer gegenläufigen Tendenz in der Ausrichtbarkeit der Domänen im angelegten elektrischen Feld und damit zu einer Verminderung der remanenten Polarisation, der beim Abschalten des elektrischen Peldes erhalten bleibenden Polarisation, und zu einer Abnahme des Kopplungsfaktors führt. Durch eine zusätzliche Dotierung mittels Akzeptoren wird die positive Wirkung der Donatoren partiell abgeschwächt, die negative Wirkung aber weitgehend aufgehoben, indem die mit der Akzeptor-Dotierung verbundene Bildung von Sauerstoff-Leerstellen bei der Sintertemperatur das Kornwachstum fördert, so dass die leichte Verschiebbarkeit der Domänenwande erhalten bleibt, was zu höheren Dielektrizitätskonstanten, piezoelektrischen Konstanten und höheren Kopplungsfaktoren führt.

Die erfindungsgemäß vorhandene Kombination von Akzeptor- und Donator-Dotierungen führt dazu, dass die negativen Eigenschaften, welche auftreten, wenn die Keramik mit nur einer der beiden Dotierungsarten dotiert wurde, kompensiert werden. Würde beispielsweise nur eine Akzeptor-Dotierung vorliegen, so führt dies oft zu sinkenden dielektrischen und piezzoelektrischen Konstanten und einem sinkenden Kopplungsfaktor, das heißt, die Konstanten liegen unter denen der undotierten Keramik. Liegt nur eine Donator-Dotierung vor, so wird das Kornwachstum gehemmt, und die Körner der Keramik erreichen nicht die gewünschte Größe. Die erfindungsgemäß vorhandene Kombination der Dotierungen hebt sich jedoch in diesen Punkten positiv von der undotierten Keramik ab. Sie weist sowohl bessere piezzoelektrische Konstanten auf sowie ein besseres Kornwachstum, welches auch noch bei tieferen Temperaturen erreicht wird, als bei undotierten PZT-Keramiken.

In kleinkörnigen Materialien sind die Domänengrenzen häufig an den Korngrenzen lokalisiert und können aufgrund der Fixierung an diesen Korngrenzen so nicht zu den piezzoelektrischen Eigenschaften beitragen. Die innere Spannung kann sich auf die Struktur des Kristallgitters, und die Stabilität von Phasen auswirken. Deshalb ist es erstrebenswert, das Kornwachstum gezielt steuern zu können.

Dies soll unter anderem über die Dotierung der PZT-Keramik erfolgen.

Erfindungsgemäß besitzt das Keramikmaterial eine Zusammensetzung gemäß der folgenden Formel:

Pb_{1-(3x/2)-a-p}NdₓK₂ₐCu₂ₚV_{Pb(x/2)-a-p}(Zr_{1-y}Ti_{y})O₃,

in den Grenzen 0,0001 ≤ x ≤ 0,06, 0,0001 ≤ a ≤ 0,03, 0,35 ≤ y ≤ 0,60 und 0 < p < ((x/2)-a), vorzugsweise im Zusammensetzungsbereich 0,015 ≤ x ≤ 0,025, 0,002 ≤ a ≤ 0,0125, 0,45 ≤ y ≤ 0,55 und 0 < p < ((x/2)-a), worin V_{Pb} eine Blei-Leerstelle darstellt.

Ausführungsformen der Erfindung können für die Anwendung als Sensor oder Aktuator in vielfältigen Geometrien hergestellt werden. Aus technologischen Gründen ergeben sich bei der Herstellung Besonderheiten im Gefüge, wie z. B. unterschiedliche Korngrößen oder unterschiedliche Phasengrenzen. Da sich aber diese Parameter auf die Eigenschaften eines ferroelektrischen Materials auswirken, ist es erstrebenswert, diese Parameter entsprechend auf die Zusammensetzung der morphotropen Phasengrenze (MPG) einzustellen. Bei der MPG ist besonders die Koexistenz der rhomboedrischen neben der tetragonalen Phase von Interesse. In einer erfindungsgemäßen Ausführungsform der Keramik ist eine Anpassung der Zusammensetzung an die MPG über den Index y möglich, über den sich das Ti-Zr-Verhältnis steuern lässt.

Eine Ausführungsform der Erfindung ist ein piezoelektrischer Aktuator. Dieser umfasst in einer bevorzugten Ausführungsform mindestens zwei Schichten des mit Nd, K und Cu dotierten PZT-Keramikmaterials zwischen denen eine Innenelektrode vorhanden ist. Diese Innenelektrode kann beispielsweise aus Cu, Pd, Ag oder einer Legierung aus diesen Metallen gefertigt sein. Vorzugsweise besteht die Innenelektrode aus Cu.

Der Einbau von K und Cu in das PZT-Gitter kann die Reaktion zwischen piezoelektrischer Keramik und dem Metall der Innenelektrode, die während des Sintervorgangs bei hohen Temperaturen stattfinden, reduzieren oder sogar unterbinden. Nimmt man beispielsweise einen Aktuator mit Cu-Innenelektrode aus einem keramischen Material, das nicht mit K und Cu dotiert wurde, gemäß der Formel

Pb_{1-x/2}NdₓV_{Pbx/2}(Zr_{1-y}Ti_{y})O₃,

wobei 0.0001 ≤ x ≤ 0.06, 0.45 ≤ Y ≤ 0.55 und V_{Pb} eine Pb-Leerstelle darstellt. Die aus der unterschiedlichen Ladung von Pb und Nd, 2+ gegenüber 3+, resultierende Leerstellenkonzentration ermöglicht eine Diffusion von Cu-Ionen aus den Innenelektroden in die Keramik, wo es zu einem Einbau der Cu-Ionen in das Kristallgitter kommt. Dieses Problem wird in einer Ausführungsform der Erfindung durch den Einbau von K⁺ und Cu⁺ -Ionen auf A-Plätzen des Kristallgitters vermindert bzw. gelöst. Die damit verbundene Kompensation der Pb-Leerstellen (V_{Pb}) auf den A-Plätzen reduziert das Bestreben des Kupfers aus den Innenelektroden in die Keramik zu diffundieren, was eine Wanderung der Cu-Ionen reduziert oder sogar komplett unterbindet.

Die ganz oder teilweise unterbundene Diffusion der Cu-Ionen hat unterschiedliche Vorteile für die aus den erfindungsgemäßen Keramiken gefertigten elektrokeramischen Bauelemente. Im Einzelnen verlieren die Innenelektroden in diesem Fall kein Material und können eine durchgängige Schicht bilden, was für eine bessere Leitfähigkeit der Innenelektroden sorgt.

Dem Übergangsbereich zwischen tetragonaler und rhomboedrischer Phase kommt bei den Ausführungsformen der Keramik besondere Bedeutung zu. Es kommt in diesem zu einer konzentrationsabhängigen Umwandlung zwischen zwei Kristallstrukturen im Keramikmaterial. Eine solche Phasengrenze wird nach Jaffe als "morphotrop" bezeichnet. Die Materialeigenschaften zeigen in diesem Bereich einige Besonderheiten, so dass sie für die technische Anwendung besonders interessant sind. Einige Materialkonstanten, die das piezoelektrische Verhalten der PZT-Keramik entscheidend beeinflussen, zeigen an der morphotropen Phasengrenze gute Werte, z. B. deutliche Maxima, wie beispielsweise die Dielektrizitätskonstante εᵣ, die piezoelektrische Ladungskonstante d₃₃ und der Kopplungsfaktor k.

Die relative Dielektrizitätskonstante εᵣ ist das Verhältnis aus der absoluten Permittivität des Keramikmaterials und der Permittivität im Vakuum, wobei die absolute Permittivität ein Maß für die Polarisierbarkeit im elektrischen Feld darstellt. Die Wirksamkeit des Piezoeffekts wird durch die piezoelektrische Ladungskonstante dij gekennzeichnet, die das Verhältnis der mechanischen Verformung zur angelegten Feldstärke bzw. das Verhältnis der Flächenladungsdichte zur angelegten mechanischen Spannung darstellt. Die Richtungsabhängigkeit des Parameters wird durch die entsprechenden Indizes angegeben. Der Index i der piezoelektrischen Ladungskonstanten gibt die Richtung des elektrischen Feldes an, der Index j die Richtung der Deformation, mit der der Kristall auf das Feld reagiert. Hierbei steht eine 1 für die x-Richtung, 2 für die y-Richtung und 3 für die z-Richtung. Die piezoelektrische Ladungskonstante d₃₃ bezeichnet somit das longitudinale Dehnungsverhalten in Richtung der z-Achse. Der Kopplungsfaktor k ist ein Maß für den Grad des piezoelektrischen Effektes. Er beschreibt das Vermögen eines piezoelektrischen Materials aufgenommene elektrische Energie in mechanische Energie umzuwandeln und umgekehrt. Hierbei steht k₃₃ für den Kopplungsfaktor der Longitudinalschwingung. Beim Longitudinal-Effekt ist die polare Achse des Kristalls kolinear zur Deformationsrichtung.

Vergleicht man die piezoelektrische Ladungskonstante d₃₃ der nur mit Nd dotierten Keramik

0,015 PbO + (Pb_{0,97}V_{Pb0,01}Nd_{0,02})(Zr_{0,5515}Ti_{0,4485})O₃ (d₃₃: 690 pm/V)

mit dem entsprechenden Ausführungsbeispiel einer ReferenzKeramik, die zusätzlich Ni aufweist

0,015 PbO + (Pb_{0,975} V_{Pb0,005}Nd_{0,02}) (Zr_{0,5515}Ti₀,₄₄₈₅)_{0,995}Ni_{0,005})O₃ (d₃₃: 740 pm/V),

so stellt man einen deutlichen Anstieg des Wertes fest, was eine größere Dehnung bei gleicher angelegter Spannung bedeutet. Eine weitere verbesserung wird durch die erfindungsgemäße PZT-Keramik mit Nd, K und Cu -Dotierung erreicht. Beispielsweise ist der Auslenkungsparamter d₃₃ gegenüber der mit Ni dotierten PZT-Referenzkeramik um 33% erhöht (vergleiche die in nachstehenden Ausführungsbeispielen angegebene Tabelle 1). Die verbesserten piezoelektrischen Eigenschaften steigern somit die Effizienz der entsprechenden Ausführungsbeispiele, in denen diese Keramik zum Einsatz kommt.

Als Ursache der Maxima physikalischer Eigenschaften an der MPG gilt die Koexistenz der rhomboedrischen und der tetragonalen Phase. Diese Koexistenz begünstigt die Ausrichtung von Domänen im elektrischen Feld und verbessert so die Polarisierbarkeit der Keramik. Dies unterstreicht nochmals die Bedeutung und Sonderstellung der MPG in der PZT-Keramik.

Ausführungsformen des erfindungsgemäßen Keramikmaterials eignen sich aufgrund der guten piezoelektrischen Eigenschaften für den Einsatz in beispielsweise Vielschichtbauelementen.

Werden mehrere Keramikschichten und Innenelektroden abwechselnd übereinander angeordnet, so erhält man ein piezoelektrisches Vielschichtbauelement. Abwechselnd ist in diesem Zusammenhang so zu verstehen, das immer auf eine bestimmte Zahl von Keramikschichten eine Innenelektrode folgt.

Gegenstand von weiteren Ausführungsformen der Erfindung ist auch ein Herstellungsverfahren für das Keramikmaterial.

Das Verfahren zur Herstellung des Keramikmaterials umfasst folgende Schritte:
A1) Herstellung eines Keramik-Rohstoffgemisches durch Zerkleinern und Mischen von Ausgangsmaterialien enthaltend Pb, Zr, Ti, Nd und Sauerstoff, B1) Einbringen einer K-haltigen Verbindung und gegebenenfalls Einbringen von Cu oder einer Cu-haltigen Verbindung, C1) Kalzinieren des Rohstoffgemisches, und D1) Sintern zur Keramik.

In einer bevorzugten Ausführungsform wird eine erste Keramikrohmasse durch Mischen von Pb, Nd, Zr, Ti und O enthaltenden Ausgangsverbindungen hergestellt und diese einem ersten Kalzinierungsschritt A11) bei einer Temperatur von z.B. zwischen 850 und 970°C, vorzugsweise zwischen 875 und 925°C, unterzogen. Nach dem Zerkleinern dieser kalzinierten Keramikrohmasse schließt sich dann entweder direkt der Verfahrensschritt C1) an oder es wird vor dem Schritt C1) der Schritt B1) durchgeführt, d.h. es wird eine K-haltige Verbindung und gegebenenfalls Cu oder eine Cu-haltige Verbindung eingebracht. Durch Einfügen des Schrittes A11) kann eine vollständigere Umsetzung und demzufolge eine homogeneres Keramikmaterial erhalten werden.

Hierbei können die Ausgangsmaterialien als Oxide vorliegen. Die Ausgangsmaterialien können aber auch in Form von beispielsweise Metallcarbonaten, Metallhydrogencarbonaten oder metallorganischen Verbindungen oder einer Mischung aus diesen vorliegen.

Die Elemente Zr und Ti können auch in Form eines Precursors wie (Zr,Ti)O₂ als Ausgangsmaterial eingesetzt werden.

Die Elemente Pb, Zr, Ti und Nd werden in ihren entsprechenden Ausgangsverbindungen entsprechend der stöchiometrischen Verhältnisse der Elemente im herzustellenden Keramikmaterial gemischt.

Die Zugabe von Nd erfolgt im allgemeinen in einem Bereich von 0,01 bis 6 mol%, vorzugsweise im Bereich von 0,5 bis 3 mol%, insbesondere bevorzugt im Bereich von 1,5 bis 2,5 mol%.

Das Einbringen einer K-haltigen Verbindung kann sowohl vor oder auch erst nach dem Kalzinieren (Verfahrensschritt C1)) erfolgen.Vorzugsweise wird als K-haltige Verbindung K₂CO₃, KOOCCH₃, K₂C₂O₄ oder eine Mischung aus diesen verwendet.

Das Einbringen von Cu kann als Cu-Metall oder als Cu-Verbindung, vorzugsweise Cu₂O, erfolgen. Vorzugsweise wird Cu nach dem Schritt C1) und vor dem Schritt D1) zugegeben. Insbesondere bevorzugt wird zudem ein Sinterhilfsmittel, vorzugsweise PbO, zugegeben. Falls PbO zugegeben wird, erfolgt die Zugabe vorzugsweise in einer Menge von bis zu 1,5 mol%.

Die Zugabe von K und Cu erfolgt jeweils im allgemeinen in einem Bereich von 0,01 bis 6 mol%, vorzugsweise im Bereich von 0,4 bis 3 mol%, insbesondere bevorzugt im Bereich von 0,4 bis 2,5 mol%. Dabei wird die K-haltige Verbindung und Cu bzw. die Cu-haltige Verbindung ebenfalls entsprechend des stöchiometrischen Verhältnisses von K bzw. Cu in Bezug auf die anderen Elemente im herzustellenden Keramikmaterial hinzugegeben.

Das Keramik-Rohstoffgemisch wird im Verfahrensschritt C1) bei einer Temperatur kalziniert, die beispielsweise zwischen 850 und 970°C, vorzugsweise zwischen 900 und 950°C, liegt. Das ermöglicht der Keramik die Bildung von Mischkristallphasen.

Die "rohe" oder auch als "grün" bezeichnete Keramik wird im Verfahrensschritt D1) gesintert. Die Sintertemperatur liegt hierbei beispielsweise zwischen 950 und 1070 °C. Somit liegt sie unter dem Schmelzpunkt von Kupfer (1083 °C), was es ermöglicht, die Innenelektroden eines piezoelektrischen Aktuators beispielsweise vollständig aus Kupfer zu fertigen, oder aus Legierungen, deren Schmelzpunkt in dem Bereich von Kupfer liegt.

Zur Formgebung kann die Mischkristallphase, die durch das Kalzinieren entsteht, in einem zwischengelagerten zusätzlichem Verfahrensschritt erneut gemahlen werden und durch Zugabe eines Binders in eine Keramikmasse überführt werden. Diese kann dann in die gewünschte Form gebracht werden, beispielsweise Grünfolien. Da der Binder im Endprodukt nicht erwünscht ist, sollte dieser thermisch bzw. hydrothermisch abbaubar sein. Hierzu eignen sich beispielsweise Binder auf Polyurethanbasis. Der Binder muss jedoch vor dem Sintern in einem vorgeschalteten thermischen Prozess entfernt werden, da sich andernfalls beim Sintern eine Degradation der Keramik infolge Reduktion zu metallischem Blei einstellt.

Es wird des weiteren ein Herstellungsverfahren für ein Vielschichtbauelement beansprucht, welches die erfindungsgemäße Keramik umfasst.

Das Verfahren zur Herstellung des Vielschichtbauelements umfasst folgende Verfahrensschritte: A2) Bereitstellen von keramischen Grünfolien, die gemäß einem der vorher beschriebenen Verfahren hergestellt werden, B2) Übereinanderschichten der keramischen Grünfolien zu einem Stapel, C2) Verfestigen des Stapels durch Laminieren, wodurch Grünteile entstehen, D2) Entbindern der Grünteile und E2) Sintern der Grünteile.

Die keramischen Grünfolien enthalten dabei bereits Ausgangsmaterialien enthaltend Pb, Zr, Ti, Nd, Sauerstoff, K und Cu.

Das Laminieren im Verfahrensschritt C2) kann beispielsweise mit einer Presskraft von 100 bis 130 Tonnen erfolgen. Die Presskraft kann hierbei auf den Binder-Typ abgestimmt sein.

Das Entbindern im Verfahrensschritt D2) kann unter inerter Atmosphäre bei 550°C erfolgen, was beispielsweise bei Kupferinnenelektroden bevorzugte Bedingungen wären. In Abwesenheit von Cu-Innenelektroden kann das Entbindern aber auch unter Luft-Atmosphäre geschehen. Die Temperatur ist hierbei beispielsweise auf das Bindermaterial und das Material der Innenelektroden abgestimmt.

Das Sintern im Verfahrensschritt E2) kann beispielsweise über 4 Stunden bei einer Temperatur bis zu 1070°C erfolgen. Ein möglicher Sintertemperaturbereich umfasst 960 bis 1100 °C, wobei auch höhere Temperaturen zum Erfolg fü̅h̅ren können. Der Bereich von 980 bis 1040 °C ist jedoch bevorzugt.

Für das Sintern im Verfahrensschritt E2) kann ein Gasgemisch verwendet werden, welches Stickstoff, Wasserstoff und Wasserdampf umfasst.

Umfasst das Vielschichtbauelement Innenelektroden, so kann das Material für die Innenelektroden zwischen den Verfahrensschritten A2) und B2) auf die Grünfolien aufgebracht, beispielsweise aufgedruckt, werden.

Es wird des weiteren ein weiteres Herstellungsverfahren für ein Vielschichtbauelement umfassend die erfindungsgemäße Keramik beansprucht, bei dessen Herstellung eine weitere Ausführungsform der Keramik entsteht.

Dieses weitere Herstellungsverfahren umfasst folgende Verfahrensschritte:
A3) Herstellen eines ersten Keramik-Rohstoffgemisches durch Zerkleinern und Mischen von Ausgangsmaterialien enthaltend Pb, Zr, Ti, Nd und Sauerstoff,
B3) Kalzinieren des ersten Keramik-Rohstoffgemisches,
C3) Zerkleinern des kalzinierten ersten Keramik-Rohstoffgemisches und Mischen mit einer K-haltigen Verbindung zur Herstellung eines zweiten Keramik-Rohstoffgemisches,
D3) Kalzinieren des zweiten Keramik-Rohstoffgemisches,
E3) Zugabe eines Binders zu dem Keramik-Rohstoffgemisch aus D3),
F3) Formen von Grünfolien aus dem Gemisch aus E3),
G3) Bedrucken der Grünfolien aus F3 mit Innenelektroden, wobei das Material der Innenelektroden Cu umfasst,
H3) Übereinanderschichten von einer Vielzahl der keramischen Grünfolien aus G3) zu einem Stapel,
I3) Verfestigen des Stapels durch Laminieren, wodurch Grünteile entstehen,
J3) Entbindern der Grünteile,
K3) Sintern der Grünteile, wobei ein Teil des Cu aus den Innenelektroden in das Keramikmaterial übergeht und in dieses eingebaut wird.

Hierbei können im Verfahrensschritt H3) zwischen die Grünfolien aus G3) auch Grünfolien entsprechend F3) geschichtet werden, also Grünfolien die nicht mit Elektrodenmaterial bedruckt wurden.

Der Verfahrensschritt E3) kann einen Polyurethan-Binder umfassen, welcher thermisch oder hydrothermisch abbaubar sein kann.

Das Material der Innenelektroden kann metallisches Cu oder Cu-Oxid umfassen. Durch das Bedrucken der Grünfolien im Verfahrensschritt G3) haben die Cu-Ionen bereits die Möglichkeit in das Keramikmaterial zu diffundieren.

Das Laminieren im Verfahrensschritt H3) kann mit einer Presskraft von 100 bis 130 Tonnen erfolgen. Durch den Druck werden Grünteile geformt.

Das Entbindern im Verfahrensschritt J3) kann unter inerter oder Luft-Atmosphäre bei 550 °C erfolgen. Bei diesem Verfahrenschritt muss die Temperatur so gewählt werden, dass die unerwünschten, oftmals organischen Bestandteile die unter anderem durch den Binder eingebracht wurden heraus gebrannt werden. Somit wird die Entbindertemperatur bevorzugt auf den Binder-Typ abgestimmt. Aber auch das Material der Innenelektroden spielt eine Rolle bei der Wahl der Entbindertemperatur. Die thermische Behandlung kann auch zur Diffusion von Cu aus dem Elektrodenmaterial in die Keramik beitragen.

Das Sintern im Verfahrensschritt K3) kann über 4 Stunden bei einer Temperatur bis zu 1070 °C erfolgen. Ein möglicher Sintertemperaturbereich umfasst 960 bis 1100 °C, wobei der Bereich von 980 bis 1040 °C bevorzugt ist, aber auch Temperaturen über 1100 °C zum gewünschten Ziel führen können.

Für das Sintern im Verfahrensschritt K3) kann ein Gasgemisch verwendet werden, das Stickstoff, Wasserstoff und Wasserdampf umfasst. Während des Sinterprozess wandern Cu-Ionen aus dem Innenelektrodenmaterial in die Keramik, wo sie dann auf A-Plätzen eingebaut werden.

Das Vielschichtbauelement kann in weiteren Schritten geschliffen und poliert werden. Im Bereich der austretenden Innenelektroden kann eine Kontaktierung, beispielsweise mit einer Kupferpaste, erfolgen. Nach dem Einbrennen der Paste kann das Vielschichtbauelement mittels der üblichen Bond-Technologie nun mit Drähten versehen werden. Hieraus resultiert somit ein piezoelektrischer Aktuator.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

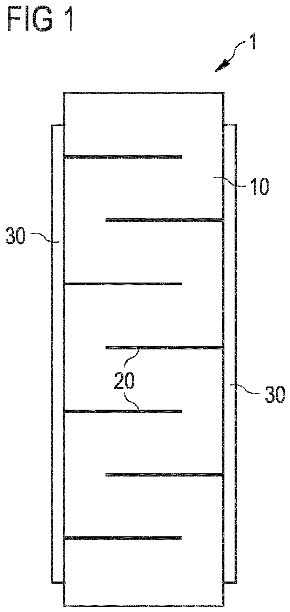

**Figur 1** zeigt schematisch den Aufbau eines PZT-Vielschicht-Bauelements (1) mit Cu-Innenelektroden (20), Keramikschichten (10) und Außenkontakten (30).

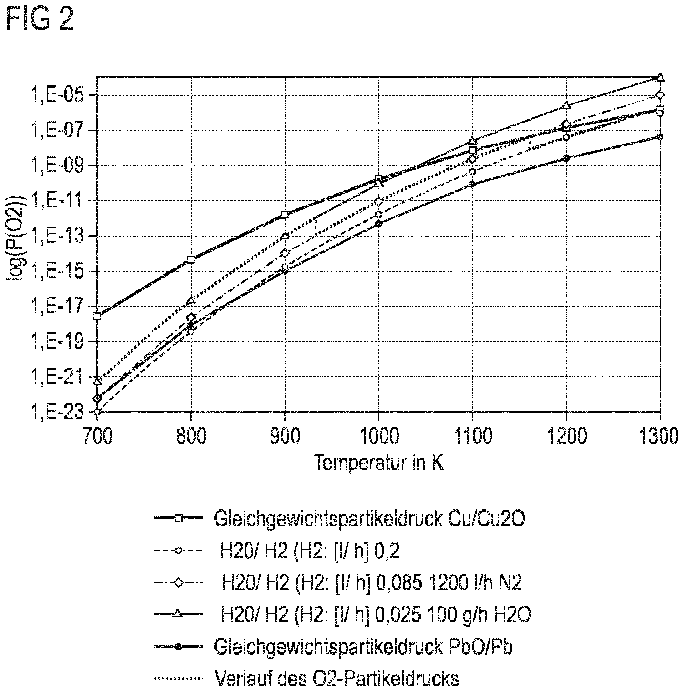

**Figur 2** zeigt das Prozessfenster mit den Gleichgewichtslinien für Cu₂O/Cu und PbTiO₃/Pb, TiO₂. Nur in diesen Grenzen darf der Sauerstoffparzialdruck variieren, wenn eine Oxidation von Cu zu Cu₂O bzw. Reduktion von PbTiO₃ zu Pb und TiO₂ vermieden werden soll.
**Figur 3A** zeigt das in Aktuatoren mit kombinierter Nd/K, Cu-Dotierung auf den A-Plätzen der PZT-Perowskit-Struktur erhaltene Keramikgefüge.
**Figur 3B** zeigt das Gefüge von Aktuatoren mit der Keramikzusammensetzung

   Pb_{0,9735}Nd_{0,02}Cu_{0,003}V_{0,0035}[(Ti_{0,4485}Zr_{0,5515})_{0,995}Ni_{0,005}]O₃

   in der neben Nd-Donatoren Cu-Akzeptoren auf den A-Plätzen und zugleich Ni-Akzeptoren auf den B-Plätzen eingebaut sind.
**Figur 3C** gibt das Gefüge von Keramikschichten in Aktuatoren mit der Keramikzusammensetzung

   Pb_{0,9685}Nd_{0,02}Cu_{0,003}V_{0,0085}(Zr_{0,5515}Ti_{0,4485})O₃

   wieder, die neben der Nd/Cu-Dotierung keine weitere Zusatzdotierung durch K-Akzeptoren auf A-Plätzen oder Ni-Akzeptoren auf B-Plätzen aufweist.

In einer bevorzugten Ausführungsform werden Pb, Ti, Zr und Nd haltige Ausgangsverbindungen, beispielsweise die Oxidkomponenten Pb₃O₄, TiO₂, ZrO₂ und Nd₂O₃, entsprechend der Nd-dotierten PZT-Zusammensetzung

Pb_{1-(3x/2}NdₓV_{x/2}(Zr_{1-y}Ti_{y})O₃

in einer Mischung mit den Grenzen 0,35 ≤ y ≤ 0,60 und 0,0001 ≤ x ≤ 0,06 und bevorzugt mit den Grenzen 0,45 ≤ y ≤ 0,55 und 0,015 ≤ x ≤ 0,025 einem ersten Umsatz, beispielsweise bei 925 °C zwei Stunden, unterzogen.

In einer Version A wird das Umsatzprodukt in einer wässrigen Aufschlämmung auf d₅₀ ≤ 1 µm gemahlen und nach dem Trocknen durch Verdampfen des Wassers zwecks besserer Homogenisierung der Bestandteile in der PZT-Perowskitstruktur ein zweites Mal umgesetzt, beispielsweise bei 950 °C für 2 h. Der anschließenden Feinmahlung, beispielsweise auf d₅₀ = 0,3 bis 0,55 pm, mit beispielsweise ZrO₂-Kugeln (≤ 0,8 nm) wird wahlweise bis zu 1,5 mol.% PbO bezogen auf die PZT-Formeleinheit als Sinterhilfsmittel zugesetzt. Nach dem erneuten Zerkleinern, gegebenenfalls unter Eindampfen und Sieben, wird das disperse Pulver unter Zusatz einer der Formel

Pb_{1-(3x/2)-a}NdₓK₂ₐV_{(x/2)-a}(Zr_{1-y}Ti_{y})O₃,

entsprechende Menge K-haltiger Verbindungen, beispielsweise K₂CO₃, KCH₃COO oder K₂C₂O₄ oder einer Mischung hiervon, in den Grenzen 0,0001 ≤ a ≤ 0,03 und bevorzugt in den Grenzen 0,002 ≤ a ≤ 0,0125 in einen Schlicker zur Herstellung von Keramikfolien überführt, wobei vorzugsweise ein nicht wässriges Dispergiermedium, entweder einer Ethanol/Toluol-Mischung in Kombination mit einem Polyvinylbutyral-Binder oder eine Methylethylketon/Isopropanol-Mischung in Kombination mit einem Polyurethan-Binder zur Anwendung gelangt. Der Einbau der K-Akzeptoren in die PZT-Perowskit-Struktur erfolgt bei dieser Version A erst nach der Entbinderung im Verlauf der Sinterung des mit Cu-Innenelektronen versehenen Folienstapels eines Aktuators.

In einer Version B wird das Pulver nach dem Umsatz, beispielsweise bei 925 °C für zwei Stunden, gleichfalls in einer wässrigen Aufschlämmung, beispielsweise auf d₅₀ ≤ 1 µm, gemahlen, aber bereits auf dieser Stufe eine der Formel

Pb_{1-(3x/2)-a}NdₓK₂ₐV_{(x/2)-a}(Zr_{1-y}Ti_{y})O₃

entsprechende Menge K-haltiger Verbindung, beispielsweise K₂CO₃, KcH₃CoO oder K₂C₂O₄ oder einer Mischung hiervon, in den Grenzen 0,0001 ≤ x ≤ 0,03 und bevorzugt in den Grenzen 0,002 ≤ a ≤ 0,0125 zugesetzt. Um Verluste an K⁺-Ionen zu vermeiden, erfolgt die Eliminierung des Wassers aus der Aufschlämmung vorzugsweise mit Hilfe eines Trockners, z.B. eines Walzentrockners. In dieser Version B werden die K⁺-Ionen bereits beim anschließenden zweiten Umsatz, beispielsweise bei 950 °C für zwei Stunden, in die PZT-Perroskit-Struktur eingebaut und dadurch fixiert. Der darauf folgenden Feinmahlung, beispielsweise auf d₅₀ = 0,3 bis 0,55 µm mit ZrO₂-Kugeln (≤ 0,8 nm), in wässriger Aufschlämmung werden vorzugsweise bis zu 1,5 mol.% PbO bezogen auf die PZT-Formeleinheit als Sinterhilfsmittel zugesetzt. Um K⁺-Ionen-Verluste infolge einer partiellen Auswaschung durch Hydrolyse zu vermeiden, gelangt auch an dieser Stelle ein Trockner, beispielsweise ein Walzentrockner, beim Verdampfen des Wassers zur Anwendung. Nach dem Sieben wird das feindisperse Pulver in gleicher Weise wie in der Version A in einen Folienschlicker überführt.

In beiden Versionen ist es bevorzugt, den Parameter y, der die morphotrophe Phasengrenze beschreibt und den als optimal erkannten Parameter x, der den K-Gehalt wiedergibt, im Ergebnis einer experimentellen Untersuchung aufeinander abzustimmen.

Beim Co-Firing mit Cu-Elektroden findet beim Sintern selbst unter einem definiert eingestellten Sauerstoffpartialdruck, der die Reduktion von PbO und ebenso die oxidative Bildung von Cu₂O vermeidet, eine geringfügige Aufnahme von Cu durch die Keramik statt. Die neben den K-Akzeptoren eingebauten Cu-Akzeptoren in dem durch den Parameter p angegebenen Mengenbereich mit 0 < p < (x/2-a) wirken sich auf das Kornwachstum zusätzlich fördernd aus, so dass den fertigen Vielschicht-Aktuator mit Cu-Innenelektroden eine Keramik mit folgender allgemeiner Zusammensetzung zugrunde liegt:

Pb_{1-(3x/2)-a-p}NdₓK₂ₐCu₂ₚV_{(x/2)-a-p}(Zr_{1-y}Ti_{y})O₃.

Folgerichtig gelingt eine solche zusätzliche Dotierung mit Cu-Akzeptoren in den Grenzen 0 < p < ((x/2)-a) auch durch einen Zusatz von CU₂O zum Schlicker während der Feinmahlung nach dem zweiten Umsatz.

Die nach der Version A oder B hergestellten Pulver werden im organischen Lösungsmittel unter Zusatz des jeweils geeigneten Binders dispergiert und standardmäßig zu Folien von beispielsweise ca. 80 µm Dicke verarbeitet, diese anschließend mit Cu-Paste bedruckt und bis zu mehreren hundert Schichten gestapelt und laminiert. Durch Schneiden entlang der Kante und der im Bereich der vorgesehenen Außenkontaktierung alternierend austretenden Cu-Innenelektroden werden Aktuatoren im Grundzustand erhalten.

Die Entfernung der organischen Binderbestandteile erfolgt zwecks Vermeidung einer unkontrollierten Oxidation der Cu-Elektroden vorzugsweise unter sehr weitgehendem Ausschluss von Sauerstoff und gelingt beispielsweise mit Wasserdampf, dem am Ende der Entbinderung bis zu ca. 500 °C auch etwas Wasserstoff zugesetzt ist, wobei ein Abbau der Polymerketten durch Hydrolyse, Depolymerisation und Steam-Reforming zu kleineren Molekülen zustande kommt, die mit dem Wasserdampf hinausgetragen werden. Dabei darf der Sauerstoffpartialdruck eine untere Grenze nicht unterschreiten, damit eine Reduktion von PbO bzw. PZT unter Bildung von Pb vermieden wird. Es wurde erkannt und in den Patentschriften EP1240675B1 und US7855488B2 dokumentiert, dass sich Binder auf der Basis von Polyurethanen aufgrund ihrer hydrolytischen Spaltbarkeit durch Wasserdampf für eine Entbinderung bis auf einen sehr geringen Restkohlenstoffgehalt von ca. 300 ppm besonders gut eignen.

Die Sinterung der entbinderten Aktuatoren wird mit einer Heizrate von beispielsweise ca. 1 K/min bei beispielsweise 1000 bis 1010 °C bei einigen Stunden Haltezeit unter den Bedingungen eines kontrollierten Sauerstoff-Partialdrucks vorgenommen, der durch Wasserdampf und Wasserstoff so eingestellt werden kann, sodass im gesamten Temperaturverlauf die Oxidation von Cu und die Bildung von Pb infolge Reduktion von PbO bzw. PZT vermieden wird. Der einzustellende Sauerstoff-Partialdruck kann aus thermodynamischen Daten in Abhängigkeit von der Temperatur berechnet und durch eine Sauerstoff-Messsonde kontrolliert werden.

Zur Vermessung können die Aktuatoren im dafür vorgesehenen Bereich alternierend austretender Elektroden an der Oberfläche durch Siebdruck mit Cu-Paste kontaktiert und diese Außenkontaktierung unter definiertem Sauerstoff-Partialdruck zwecks Vermeidung der Oxidation von Cu in einem kurzen thermischen Prozessschritt eingebrannt werden.

Die Erfindung wird in folgenden Ausführungsbeispielen näher erläutert.

Gemäß der allgemeinen Formel

Pb_{1-(3x/2)-a-p}NdₓK₂ₐCu₂ₚV_{(x/2)-a-p}(Zr_{1-y}Ti_{y})O₃

wird ein Referenzbeispiel mit den Parametern x = 0,02, a = 0,0075, y = 0,4485 und p = 0 ausgewählt, woraus sich die folgende Zusammensetzung ergibt:

Pb_{0,9625}Nd_{0,02}K_{0,015}V_{0,0025}(Zr_{0,5515}Ti_{0,4485})O₃

Zunächst werden die Rohstoffe Pb₃O_{4,} TiO_{2,} ZrO₂ und Nd₂O₃, deren Verunreinigungsgehalt kontrolliert und deren Metallgehalt jeweils gesondert bestimmt wurde, im entsprechenden Molverhältnis ohne den Zusatz einer Kaliumverbindung (a = 0) eingewogen und mit ZrO₂-Mahlkörpern 24 Stunden in einem wässrigen Schlicker rotierend gemischt. Nach dem Eindampfen und Sieben wird die Mischung bei 925 °C mit einer Haltezeit von zwei Stunden in einer ZrO₂-Kapsel umgesetzt, wobei sich die Nd-dotierte PZT-Verbindung

Pb_{0,97}Nd_{0,02}V_{0,01}(Zr_{0,5515}Ti_{0,4485})O₃

bereits weitgehend bildet.

In einer Version A wird das Reaktionsprodukt mit ZrO₂-Kugeln (2 mm) in einer wässrigen Aufschlämmung auf eine mittlere Korngröße d₅₀ ≤ 1 µm gemahlen, das Wasser abgedampft und der Rückstand zwecks Vervollständigung der Reaktion ein zweites Mal umgesetzt, diesmal zwei Stunden bei 950 °C. Der anschließenden Feinmahlung auf d₅₀ = 0,3 bis 0,55 µm mit ZrO₂-Kugeln (≤ 0,8 mm) werden 0,8 mol% PbO bezogen auf die PZT-Formeleinheit als Sinterhilfsmittel zugesetzt. Nach dem erneuten Eindampfen und Sieben wird das disperse Pulver unter Zusatz von 1,5 mol% KCH₃COO (a = 0,0075) bezogen auf die PZT-Formeleinheit in einen Schlicker zur Herstellung von Keramikfolien überführt, wobei als nicht wässriges Dispergiermedium eine Methylethylketon/Isopropanol-Mischung in Kombination mit einem Polyurethan-Binder zur Anwendung gelangt. Die Folien werden mit einer Cu-Paste bedruckt, bis zu mehreren hundert Schichten gestapelt, laminiert und die einzelnen Aktuatoren durch Herausschneiden aus dem verdichteten Stapel erhalten.

Der Einbau der K-Akzeptoren in die PZT-Perowskitstruktur erfolgt bei dieser Version A nach der Entbinderung im Verlauf der Sinterung des mit Cu-Innenelektronen versehenen Folienstapels eines Aktuators. Außerdem nehmen die Keramikschichten während der Sinterverdichtung etwas Cu aus den Innenelektroden als Cu-Akzeptoren auf. Mit p = 0,0015 folgt daraus für die Keramikschichten in den Aktuatoren die Zusammensetzung

Pb_{0,961}Nd_{0,02}K_{0,015}Cu_{0,003}V_{0,008} (Zr_{0,5515}Ti_{0,4485})O₃.

In einer Version B wird das nach dem ersten Umsatz bei 925 °C erhaltene Reaktionsprodukt gleichfalls mit ZrO₂-Kugeln (2 mm) in einer wässrigen Aufschlämmung auf eine mittlere Korngröße d₅₀ ≤ 1 µm gemahlen, dabei aber bereits auf dieser Stufe eine der Formel

Pb_{0,9625}Nd_{0,02}K_{0,015}V_{0,0025}(Zr_{0,5515}Ti_{0,4485})O₃

entsprechende Menge K₂CO₃, KCH₃COO oder K₂C₂O₄ (a = 0,0075) zugesetzt. Um Verluste an K⁺-Ionen zu vermeiden, erfolgt die Eliminierung des Wassers aus der Aufschlämmung mit Hilfe eines Walzentrockners. In dieser Version B werden die K⁺-Ionen bereits beim anschließenden zweiten Umsatz bei 950 °C zwei Stunden in der PZT-Perowskit-Struktur eingebaut und dadurch fixiert. Der darauf folgenden Feinmahlung auf d₅₀ = 0,3 bis 0,55 µm mit ZrO₂-Kugeln (= 0,8 mm) in wässriger Aufschlämmung werden 0,8 mol% PbO bezogen auf die PZT-Formeleinheit als Sinterhilfsmittel zugesetzt. Um K⁺-Ionen-Verluste infolge einer partiellen Auswaschung durch Hydrolyse zu vermeiden, gelangt auch an dieser Stelle ein Walzentrocken beim Verdampfen des Wassers zur Anwendung. Nach dem Sieben wird das feindisperse Pulver in gleicher Weise wie bei der Version A in einen Folienschlicker überführt und zu Aktuatoren mit Cu-Innenelektroden weiterverarbeitet, wobei sich in den Keramikschichtung die Zusammensetzung

Pb_{0,961}Nd_{0,02}K_{0,015}Cu_{0,003}V_{0,008}(Zr_{0,5515}Ti_{0,4485})O₃

ausbildet.

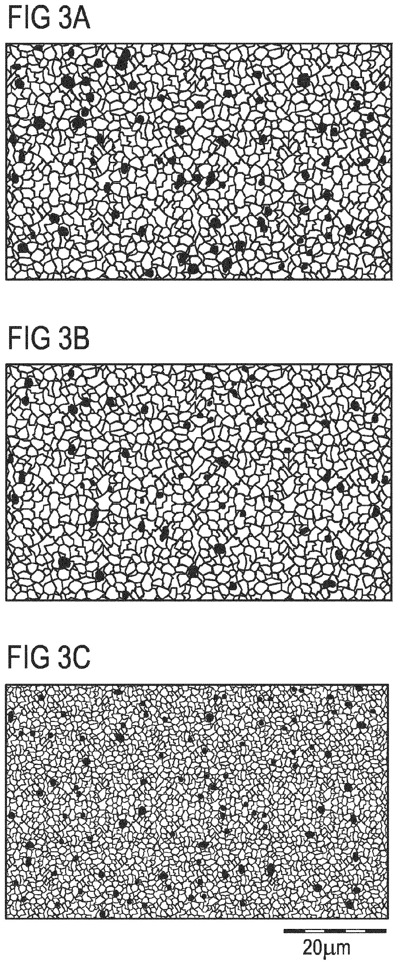

Man erkennt, dass die K-Akzeptordotierung auf A-Plätzen der PZT-Perroskit-Struktur in Figur 3A zu einer vergleichbaren Erhöhung der mittleren Korngröße wie die Ni-Akzeptordotierung auf den B-Plätzen in Figur 3B führt: d₅₀ ca. 3 µm.

Die in der Tabelle 1 zusammengestellten Eigenschaften zeigen, dass die durch Nd/K, Cu-Dotierung auf den A-Plätzen modifizierte PZT-Keramik (Figur 3A) gegenüber der Nd/Cu-Dotierung auf A-Plätzen und Ni-Dotierung auf B-Plätzen (Figur 3B) im Aufbau eines Aktuators zu einem um 33 % erhöhten Wert für den Auslenkungsparameter d₃₃ führt. Dabei wird zugleich eine Erhöhung des Kopplungsparameters K₃₃ sowie eine Absenkung der Verlustenergie erreicht.

**Tabelle 1: Piezoelektrische und piezomechanische Eigenschaften der Aktuatoren mit Nd/K, Cu-dotierter PZT-Keramik der Zusammensetzung**

| Pb_{0,961}Nd_{0,02}K_{0,015}Cu_{0,003}V"_{0,008}(Zr_{0,5515}Ti_{0,4485})O₃ | | |
|---|---|---|
| sowie für Aktuatoren mit Nd/Cu, Ni-dotierter PZT-Keramik der Zusammensetzung | | |
| Pb_{0,9735}Nd_{0,02}Cu_{0,003}V_{0,0035}[(Ti_{0,4485}Z r_{0,5515})₀,₉₉₅Ni_{0,005}]O₃ . | | |
| Eigenschaft | Nd/K, Cu-dotierte PZT-Keramik | Nd/Cu, Ni-dotierte PZT-Keramik |
| d33 | 650 pm/V | 490 pm/V |
| ε | 2950 | 2360 |
| E-Modul c₃₃ | 28 GPa | 34 GPa |
| Kopplung k₃₃ | 69,5 % | 69,5 % |
| Verluste elektrischer Energie | 29 % | 31 % |

Die Messungen wurden an Vielschicht-Aktuatoren mit den Abmessungen von 3,8 x 3,8 x 30 mm³ durchgeführt. Bei der Messung wurden eine elektrische Feldstärke von 3 kV/mm und eine mechanische Vorspannung von 27 MPA mit der Federkonstante für die mechanische Belastung des Aktuators von 1 n/µm verwendet.

## Patentansprüche

1. Keramikmaterial, umfassend Bleizirkonat-Titanat, das zusätzlich Nd, K und Cu enthält, mit einer Zusammensetzung gemäß der folgenden Formel:
Pb_{1-(3x/2)-a-p}NdₓK₂ₐCu₂ₚV_{Pb(x/2)-a-p}(Zr_{1-y}Ti_{y})O_{3,}
in den Grenzen 0,0001 ≤ x ≤ 0,06, 0,0001 ≤ a ≤ 0,03, 0,35 ≤ y ≤ 0,60 und 0 < p < ((x/2)-a), vorzugsweise im Zusammensetzungsbereich 0,015 ≤ x ≤ 0,025, 0,002 ≤ a ≤ 0,0125, 0,45 ≤ y ≤ 0,55 und 0 < p < ((x/2)-a), worin V_{Pb} eine Blei-Leerstelle darstellt.

2. Keramikmaterial nach Anspruch 1, bei dem das Bleizirkonat-Titanat die allgemeine Zusammensetzung ABO₃ eines Perowskit-Gitters aufweist, wobei A für die A-Plätze und B für die B-Plätze des Perowskit-Gitters stehen und Nd, K und Cu A-Plätze im Perowskit-Gitter einnehmen.

3. Elektrokeramisches Bauelement, umfassend ein Keramikmaterial nach einem der vorhergehenden Ansprüche.

4. Elektrokeramisches Bauelement nach Anspruch 3, ausgebildet als piezoelektrischer Aktuator.

5. Piezoelektrischer Aktuator nach Anspruch 4, umfassend mindestens zwei Schichten umfassend ein Keramikmaterial nach einem der Ansprüche 1 oder 2, und eine Innenelektrode, vorzugsweise eine Cu-Innenelektrode, zwischen diesen Schichten.

6. Verfahren zur Herstellung eines Keramikmaterials nach einem der Ansprüche 1 oder 2, umfassend folgende Schritte,
A1) Herstellung eines Keramik-Rohstoffgemisches durch Zerkleinern und Mischen von Ausgangsmaterialien enthaltend Pb, Zr, Ti, Nd und Sauerstoff,
B1) Einbringen einer K-haltigen Verbindung und Einbringen von Cu oder einer Cu-haltigen Verbindung,
C1) Kalzinieren des Rohstoffgemisches,
D1) Sintern zur Keramik.

7. Verfahren nach Anspruch 6, wobei nach dem Verfahrensschritt A1) und vor dem Verfahrensschritt B1) ein zusätzlicher Verfahrensschritt A11) durchgeführt wird, worin das Keramik-Rohstoffgemisch kalziniert und anschließend zerkleinert wird.

8. Verfahren nach Anspruch 6 oder 7, wobei die Zugabe von Nd in einem Bereich von 0,01 bis 6 mol% erfolgt.

9. Verfahren nach einem der Ansprüche 6 bis 8, wobei das Einbringen einer K-haltigen Verbindung und von Cu oder einer Cu-haltigen Verbindung vor dem Kalzinieren im Verfahrensschritt C1) erfolgt.

10. Verfahren nach einem der Ansprüche 6 bis 8, wobei das Einbringen einer K-haltigen Verbindung und von Cu oder einer Cu-haltigen Verbindung nach dem Kalzinieren im Verfahrensschritt C1) erfolgt.

11. Verfahren nach einem der Ansprüche 6 bis 10, nach dem Verfahrensschritt C1) und vor dem Verfahrensschritt D1) ein zusätzlicher Verfahrensschritt C11) durchgeführt wird, worin das kalzinierte Keramik-Rohstoffgemisch zerkleinert und mit bis zu 1,5 mol-% PbO und gegebenenfalls Cu₂O vermischt wird.

12. Verfahren nach einem der Ansprüche 6 bis 10, wobei das Einbringen von Cu im Verfahrensschritt D1) erfolgt.

13. Verfahren nach einem der Ansprüche 6 bis 12, wobei die Zugabe von K und Cu in einem Bereich von 0,01 bis 6 mol% erfolgt.

14. Verfahren nach einem der Ansprüche 6 bis 13, wobei vor dem Verfahrensschritt D1) aus dem einen Binder umfassenden Keramik-Rohstoffgemisch keramische Grünfolien geformt werden.

15. Verfahren zur Herstellung eines elektrokeramischen Vielschicht-Bauelements, umfassend,
A2) Bereitstellen von keramischen Grünfolien gemäß dem Verfahren nach Anspruch 14 unter Weglassen des Sinterschritts,
B2) Übereinanderschichten der keramischen Grünfolien zu einem Stapel,
C2) Verfestigen des Stapels durch Laminieren, wodurch Grünteile entstehen,
D2) Entbindern der Grünteile,
E2) Sintern der Grünteile.

16. Verfahren zur Herstellung eines Vielschicht-Bauelements umfassend das Keramikmaterials nach einem der Ansprüche 1 oder 2, umfassend,
A3) Herstellen eines ersten Keramik-Rohstoffgemisches durch Zerkleinern und Mischen von Ausgangsmaterialien enthaltend Pb, Zr, Ti, Nd und Sauerstoff,
B3) Kalzinieren des ersten Keramik-Rohstoffgemisches,
C3) Zerkleinern des kalzinierten ersten Keramik-Rohstoffgemisches und Mischen mit einer K-haltigen Verbindung zur Herstellung eines zweiten Keramik-Rohstoffgemisches,
D3) Kalzinieren des zweiten Keramik-Rohstoffgemisches,
E3) Zugabe eines Binders zu dem Keramik-Rohstoffgemisch aus D3),
F3) Formen von Grünfolien aus dem Gemisch aus E3),
G3) Bedrucken der Grünfolien aus F3 mit Innenelektroden, wobei das Material der Innenelektroden Cu umfasst,
H3) Übereinanderschichten von einer Vielzahl der keramischen Grünfolien aus G3) zu einem Stapel,
I3) Verfestigen des Stapels durch Laminieren, wodurch Grünteile entstehen,
J3) Entbindern der Grünteile,
K3) Sintern der Grünteile, wobei ein Teil des Cu aus den Innenelektroden in das Keramikmaterial übergeht und in dieses eingebaut wird.

17. Verfahren nach Anspruch 16, wobei das Material der Innenelektroden metallisches Cu oder Cu-Oxid umfasst.

## Claims

1. Ceramic material, comprising lead zirconate titanate, which additionally contains Nd, K and Cu, having a composition according to the following formula:
Pb_{1-(3x/2)-a-p}NdₓK₂ₐCu₂ₚV_{Pb(x/2)-a-p}(Zr_{1-y}Ti_{y})O_{3,}
within the limits 0.0001 ≤ x ≤ 0.06, 0.0001 ≤ a ≤ 0.03, 0.35 ≤ y ≤ 0.60 and 0 < p < ((x/2)-a), preferably in the composition range 0.015 ≤ x ≤ 0.025, 0.002 ≤ a ≤ 0.0125, 0.45 ≤ y ≤ 0.55 and 0 < p < ((x/2)-a), in which V_{Pb} represents a lead vacancy.

2. Ceramic material according to Claim 1, in which the lead zirconate titanate has the general composition ABO₃ of a perovskite lattice, wherein A represents the A sites and B represents the B sites of the perovskite lattice and Nd, K and Cu occupy A sites in the perovskite lattice.

3. Electroceramic component comprising a ceramic material according to one of the preceding claims.

4. Electroceramic component according to Claim 3, in the form of a piezoelectric actuator.

5. Piezoelectric actuator according to Claim 4, comprising at least two layers comprising a ceramic material according to one of Claims 1 and 2 and an inner electrode, preferably a Cu inner electrode, between these layers.

6. Method for producing a ceramic material according to one of Claims 1 and 2, comprising the following steps:
A1) producing a ceramic raw material mixture by comminuting and mixing starting materials containing Pb, Zr, Ti, Nd and oxygen,
B1) introducing a K-containing compound and introducing Cu or a Cu-containing compound,
C1) calcining the raw material mixture,
D1) sintering to form the ceramic.

7. Method according to Claim 6, wherein an additional method step A11), in which the ceramic raw material mixture is calcined and then comminuted, is carried out after method step A1) and before method step B1).

8. Method according to Claim 6 or 7, wherein Nd is added in a range of from 0.01 to 6 mol%.

9. Method according to one of Claims 6 to 8, wherein a K-containing compound and Cu or a Cu-containing compound are introduced before the calcining in method step C1).

10. Method according to one of Claims 6 to 8, wherein a K-containing compound and Cu or a Cu-containing compound are introduced after the calcining in method step C1).

11. Method according to one of Claims 6 to 10, wherein an additional method step C11), in which the calcined ceramic raw material mixture is comminuted and mixed with up to 1.5 mol% PbO and if appropriate Cu₂O, is carried out after method step C1) and before method step D1).

12. Method according to one of Claims 6 to 10, wherein Cu is introduced in method step D1).

13. Method according to one of Claims 6 to 12, wherein K and Cu are added in a range of from 0.01 to 6 mol%.

14. Method according to one of Claims 6 to 13, wherein, before method step D1), ceramic green sheets are formed from the ceramic raw material mixture comprising a binder.

15. Method for producing an electroceramic multilayer component, comprising:
A2) providing ceramic green sheets as per the method according to Claim 14 omitting the sintering step,
B2) layering the ceramic green sheets on top of one another to form a stack,
C2) consolidating the stack by lamination, as a result of which green parts are formed,
D2) debindering the green parts,
E2) sintering the green parts.

16. Method for producing a multilayer component comprising the ceramic material according to one of Claims 1 and 2, comprising:
A3) producing a first ceramic raw material mixture by comminuting and mixing starting materials containing Pb, Zr, Ti, Nd and oxygen,
B3) calcining the first ceramic raw material mixture,
C3) comminuting the calcined first ceramic raw material mixture and mixing with a K-containing compound to produce a second ceramic raw material mixture,
D3) calcining the second ceramic raw material mixture,
E3) adding a binder to the ceramic raw material mixture of D3),
F3) forming green sheets from the mixture of E3),
G3) printing inner electrodes on the green sheets of F3, the material of the inner electrodes comprising Cu,
H3) layering a multiplicity of the ceramic green sheets of G3) on top of one another to form a stack,
I3) consolidating the stack by lamination, as a result of which green parts are formed,
J3) debindering the green parts,
K3) sintering the green parts, some of the Cu being transferred from the inner electrodes into the ceramic material and being incorporated therein.

17. Method according to Claim 16, wherein the material of the inner electrodes comprises metallic Cu or Cu oxide.

## Revendications

1. Matériau céramique, comprenant du zircono-titanate de plomb, qui contient en outre Nd, K et Cu, avec une composition répondant à la formule suivante:
Pb_{1-(3x/2)-a-p}NdₓK₂ₐCu₂ₚV_{Pb(x/2)-a-p}(Zr_{1-y}Ti_{y})O₃,
dans les limites 0,0001 ≤ x ≤ 0, 06, 0,0001 ≤ a ≤ 0,03, 0,35 ≤ y ≤ 0,60, et 0 < p < [(x/2)-a], de préférence dans la plage de composition 0,015 ≤ x ≤ 0,025, 0,002 ≤ a ≤ 0,0125, 0,45 ≤ y ≤ 0,55 et 0 < p < [(x/2)-a], dans laquelle V_{Pb} représente une position vide de plomb.

2. Matériau céramique selon la revendication 1, dans lequel le zircono-titanate de plomb présente la composition générale ABO₃ d'un réseau pérovskite, dans lequel A représente les emplacements A et B les emplacements B du réseau pérovskite et Nd, K et Cu occupent des emplacements A dans le réseau pérovskite.

3. Composant électro-céramique, comprenant un matériau céramique selon l'une des revendications précédentes.

4. Composant électro-céramique selon la revendication 3, réalisé sous forme d'actionneur piézoélectrique.

5. Actionneur piézoélectrique selon la revendication 4, comprenant au moins deux couches comprenant un matériau céramique selon une des revendications 1 ou 2, et une électrode intérieure, de préférence une électrode intérieure de Cu, entre ces couches.

6. Procédé de fabrication d'un matériau céramique selon une des revendications 1 ou 2, comprenant les étapes suivantes:
A1) fabrication d'un mélange de matière première céramique par broyage et mélange de matières premières contenant Pb, Zr, Ti, Nd et oxygène,
B1) introduction d'un composé contenant du K et introduction de Cu ou d'un composé contenant du Cu,
C1) calcination du mélange de matières premières,
D1) frittage en céramique.

7. Procédé selon la revendication 6, dans lequel après l'étape de procédé A1) et avant l'étape de procédé B1) on exécute une étape de procédé supplémentaire A11), dans laquelle le mélange de matière première céramique est calciné et ensuite broyé.

8. Procédé selon la revendication 6 ou 7, dans lequel on effectue l'ajout de Nd dans une plage de 0,01 à 6 % molaires.

9. Procédé selon l'une quelconque des revendications 6 à 8, dans lequel on effectue l'introduction d'un composé contenant du K et de Cu ou d'un composé contenant du Cu avant la calcination à l'étape de procédé C1).

10. Procédé selon l'une quelconque des revendications 6 à 8, dans lequel on effectue l'introduction d'un composé contenant du K et de Cu ou d'un composé contenant du Cu après la calcination à l'étape de procédé C1).

11. Procédé selon l'une quelconque des revendications 6 à 10, dans lequel après l'étape de procédé C1) et avant l'étape de procédé D1) on exécute une étape de procédé supplémentaire C11), dans laquelle on broie le mélange de matière première céramique calciné et on le mélange avec jusqu'à 1,5 % molaires de PbO et éventuellement du Cu₂O.

12. Procédé selon l'une quelconque des revendications 6 à 10, dans lequel on effectue l'introduction de Cu dans l'étape de procédé D1).

13. Procédé selon l'une quelconque des revendications 6 à 12, dans lequel l'on effectue l'addition de K et de Cu dans une plage de 0,01 à 6 % molaires.

14. Procédé selon l'une quelconque des revendications 6 à 13, dans lequel avant l'étape de procédé D1) on forme des feuilles céramiques crues en un mélange de matière première céramique contenant un liant.

15. Procédé de fabrication d'un composant électro-céramique multicouche, comprenant
A2) la préparation de feuilles céramiques crues par le procédé selon la revendication 14 en omettant l'étape de frittage,
B2) la superposition de feuilles céramiques crues en une pile,
C2) la consolidation de la pile par laminage, créant ainsi des pièces crues,
D2) l'élimination du liant des pièces crues,
E2) le frittage des pièces crues.

16. Procédé de fabrication d'un composant multicouche comprenant le matériau céramique selon une des revendications 1 ou 2, comprenant
A3) la fabrication d'un premier mélange de matière première céramique par broyage et mélange de matières premières contenant Pb, Zr, Ti, Nd et oxygène,
B3) la calcination du premier mélange de matière première céramique,
C3) le broyage du premier mélange de matière première céramique calciné et le mélange avec un composé contenant du K pour la fabrication d'un deuxième mélange de matière première céramique,
D3) la calcination du deuxième mélange de matière première céramique,
E3) l'addition d'un liant au mélange de matière première céramique de D3),
F3) la formation de feuilles crues à partir du mélange de E3),
G3) le marquage des feuilles crues de F3) avec des électrodes intérieures, dans lequel le matériau des électrodes intérieures contient du Cu,
H3) l'empilement d'une multiplicité des feuilles céramiques crues de G3) en une pile,
I3) la consolidation de la pile par laminage, créant ainsi des pièces crues,
J3) l'élimination du liant hors des pièces crues,
K3) le frittage des pièces crues, dans lequel une partie du Cu provenant des électrodes intérieures passe dans le matériau céramique et est incorporé dans celui-ci.

17. Procédé selon la revendication 16, dans lequel le matériau des électrodes intérieures comprend du Cu ou de l'oxyde de Cu.
